# EUROPÄISCHE PATENTSCHRIFT

(11) **EP 1 900 493 B1**
(45) Veröffentlichungstag und Bekanntmachung des Hinweises auf die Patenterteilung: **27.07.2011**
(21) Anmeldenummer: 07116145.9
(22) Anmeldetag: 11.09.2007
(51) Int. Cl.: B29C 35/10, B29C 59/14, C23C 16/04, C23C 16/50, C23C 16/54

(54) **Verfahren zur Modifizierung von Innenoberflächen rohrförmiger Hohlkörper mittels Plasma sowie System zur Durchführung des Verfahrens**
Method for modifying inner surfaces of tubular hollow bodies using plasma and system using the same
Procédé destiné à la modification de surfaces intérieures des corps creux tubulaires au moyen d'un plasma, et système mettant en oeuvre ledit procédé

(30) Priorität: 13.09.2006 DE 102006043036
(43) Veröffentlichungstag der Anmeldung: 19.03.2008
(73) Patentinhaber: LeadX Aktiengesellschaft, 9491 Ruggell (LI)
(72) Erfinder: Skufca, Peter Maks, 1230 Domzale (SI)
(74) Vertreter: Winter, Brandl, Fürniss, Hübner, Röss, Kaiser, Polte - Partnerschaft

(56) Entgegenhaltungen:
- EP-A- 0 887 438
- DD-A1- 227 730
- DE-A1- 2 712 993
- JP-A- 62 167 882
- JP-A- 63 137 167

## Beschreibung

Die Erfindung bezieht sich auf ein Verfahren und ein darauf gerichtetes System zum plasmagestützten Behandeln von Innenoberflächen von strangförmigen Hohlkörpern. Da solche Hohlkörper in den meisten Fällen Schläuche sind, wird im Folgenden kurz von "Schläuchen" gesprochen; selbstverständlich können aber auch Rohre und andere vergleichbare Hohlkörper mittels der Erfindung behandelt werden. Beispielsweise können Polymerschläuche (ein- oder mehrschichtig), Gummischläuche, Glas- oder Metallrohre usw. behandelt werden. Insbesondere bezieht sich die Erfindung auf ein Verfahren und eine Vorrichtung zur plasmaunterstützten Beschichtung von Schläuchen.

Derartige Verfahren sind im Stand der Technik bekannt. Z.B. offenbaren die DE 102 45 459 A1 und ihre Folgeanmeldung DE 103 05 546 A1 innenbeschichtete Plastikrohre. Dabei wird ein Rohr über eine äußere Hochfrequenzquelle von außen mit einem elekromagnetischen Feld beaufschlagt. Das Rohr wird dazu an einer mit der Quelle verbundenen Ringelektrode vorbeigezogen. Über eine vakuumdichte Gasdurchführung wird in das Rohr Gas, z.B. Argon, Wasserstoff, Beschichtungsmaterial o.ä. mit einem Druck zwischen 0,3 und 15 mbar eingeführt, das unter Einfluß der Hochfrequenz zu Plasma wird. Vor Eintritt in den Plasmabereich wird das Rohr bis auf 400°C vorgeheizt. Prozessabgase werden von einer gasausgangsseitig angeschlossenen Vakuumpumpe abgesaugt.

Die DE 103 02 067 erörtert ein Verfahren zur Stabilisierung der Oberflächenspannung eines Substrats aus thermoplastischem Polymer. Dabei wird die Oberfläche einem Plasma ausgesetzt, so dass sich die Oberflächenspannung erhöht. In einem weiteren Schritt wird die plasmabehandelte Oberfläche mit einem flüssigen Medium derart in Kontakt gebracht, dass die erhöhte Oberflächenspannung stabilisiert wird.

Nach der DE 10 2004 054 662 wird direkt bei der Herstellung eines Hohlprofils ein im Inneren liegender Energieabsorber, der an einer Plastifiziereinheit zur Herstellung des Profils hängt, in das Hohlprofil eingebracht. Diesem Energieabsorber wird nach einer Ausführungsform durch das Hohlprofil hindurch induktiv, kapazitiv oder mittels Strahlung Energie zugeführt. Alternativ erhält er Energie über die Verbindung zu der Plastifiziereinheit. Der Absorber wandelt die Energie um und gibt sie an die Innenwand des Hohlprofils weiter.

Alternativ kann die Energie von außen auch statt einem Absorber einem zur Erzeugung eines Plasmas geeigneten Gas zugeführt werden, das in den Innenraum des Hohlprofils eingeführt wird. Das Gas wird vorzugsweise auf einem dem Außendruck entsprechenden Druck gehalten, um ein Kollabieren des Hohlprofils zu vermeiden.

Die DD 227 730 A1 wird als nächstkommender Stand der Technik angesehen, der ein Verfahren nach dem Oberbegriff des vorliegenden Anspruchs 1 und ein darauf bezogenes System zeigt.

Ausgehend davon besteht die Aufgabe der Erfindung darin, ein Verfahren und ein System zur Plasmabehandlung der inneren Oberflächen von Schläuchen zu schaffen.

Diese Aufgabe wird durch ein Verfahren nach Anspruch 1 und ein darauf bezogenes System gelöst. Vorteilhafte Weiterbildungen sind in den abhängigen Ansprüchen aufgeführt.

Im Unterschied zum nächstkommenden Stand der Technik wird erfindungsgemäß eine im Hohlkörper geführte Sonde verwendet, um die von außerhalb des Hohlkörpers wie im Stand der Technik induktiv oder kapazitiv zugeführte Energie an das Plasmaträgergas abzugeben, um das Plasma zu erzeugen.

Durch die Verwendung der Sonde kann die Plasmaerzeugung deutlich besser kontrolliert werden, weil die Entladung über an der Sonde angebrachte Elektroden steuerbar ist. Darüberhinaus kann die Sonde, falls das erfindungsgemäße System mit Unterdruck betrieben wird, den Hohlkörper stützen und somit das Kollabieren verhindern.

Nach einer besonders vorteilhaften Ausführungsform wird die Sonde nicht nur von außen mit Energie versorgt, sondern auch - beispielsweise über Magnete oder einen durch den Schlauch führenden Draht - von außen gehalten, so dass der zu behandelnde Hohlkörper und die Sonde relativ zueinander zumindest in der Längsrichtung frei bewegbar sind. Im Falle des Haltens über einen Draht kann auch die Energieversorgung der Sonde über diesen Draht erfolgen. Ferner kann auch ein Draht (oder mehrere im Schlauch liegende Drähte) nur der Energieversorgung der Sonde dienen, die dann nicht an dem Draht befestigt sein muss, sondern in der Art eines "Stromabnehmers" nur Energie aus diesem Draht aufnimmt, während sie durch andere Kräfte daran entlang geführt wird.

Diese Ausführung hat den Vorteil, dass auch eine Nachbehandlung des Schlauchs, beispielsweise zur Innenbeschichtung, ohne größeren Aufwand möglich ist, selbst wenn der Schlauch bereits fertiggestellt wurde und nicht direkt aus der Plastifiziereinheit kommt. Wird die Sonde von außen gehalten, könnte erfindungsgemäß sogar ein bereits verlegter Schlauch noch beschichtet werden, was völlig neue Reparaturmöglichkeiten eröffnet.

Besonders bevorzugt wird die Sonde berührungsfrei gehalten bzw. relativ zum Schlauch bewegt. Neben den oben genannten Magnet- oder allgemeiner elektromagnetischen Kräften können dazu auch weitere auftretende Kräfte eingesetzt werden. Beispielsweise kann bei entsprechender Ausgestaltung der Sonde auf einer Seite derselben ein Unterdruck im Schlauch hervorgerufen werden, der bei entsprechender Lagerung im Zusammenspiel mit der auf die Sonde wirkenden Schwerkraft die Sonde am gewünschten Platz hält, während der Schlauch daran vorbeibewegt wird. Umgekehrt könnte bei entsprechender Ausgestaltung auch die Sonde durch Unterdruck durch den ruhenden (beispielsweise bereits verlegten) Schlauch gezogen werden. Dies kann besonders dann vorteilhaft realisiert werden, wenn ein Unterdruckplasma eingesetzt wird, weil in diesem Fall der Unterdruck gemeinsam mit der Reibung der Sonde im Schlauch für die gleichmäßige Fortbewegung sorgt und gleichzeitig die Voraussetzungen für die Plasmaerzeugung schafft. In diesem Fall bewegt sich die Sonde in Richtung hin zu dem von ihr ausgehenden Plasmastrahl und kann dabei beispielsweise zusätzlich die frisch plasmabehandelte Oberfläche glätten.

Je nach Dicke des zu behandelnden Schlauches kann die eigentliche Plasmaerzeugung auf unterschiedliche Weise erfolgen. Im Stand der Technik wird das Plasma meist von außen ionisiert. Demgegenüber kann die eingesetzte Sonde zur Ionisation verschiedene Spannungsverteiler nutzen, so dass ein Plasma je nach Aufbau der Sonde auf ihrer Vorder- oder Rückseite oder an ihrer Seiten- bzw. Umfangsfläche erzeugt wird. Wenn Schläuche mit eher kleinerem Durchmesser zu beschichten sind, kann der gesamte Raum vor der Sonde mit Plasma gefüllt werden, bei Schläuchen mit größerem Durchmesser dürfte dagegen eine Ionisation des Trägergases über an der Sonde in Schlauchrichtung hintereinander angebrachte Ringelektroden, die zu einem Plasma vorwiegend an der Seite der Sonde führen, effektiver sein.

Erfindungsgemäß ist der Sondenkörper kegelartig geformt. Dadurch kann der Sondenkörper einfacher eingeführt werden. Darüber hinaus erleichtert es die Kegelform, in halbgefüllten Schläuchen Material zu verteilen. Beispielsweise kann im Schlauch eingefülltes Pulver zu den Schlauchinnenseiten verdrängt werden und dort unter Einfluss des Plasmas mit der Schlauchinnenfläche reagieren, z.B. um eine Beschichtung herzustellen, insbesondere wenn das Pulver plasmareaktiv ist, d.h. unter Plasmaeinfluss mit der Innenoberfläche des Schlauchs oder mit einem anderen, z.B. gasförmig oder flüssig zugeführten Material reagiert und so zur Modifikation der Schlauchinnenfläche beiträgt. Alternativ könnte das Pulver durch den Plasmastrahl oder Plasma-Beam polymerisierende und/oder mit der Oberfläche verschmelzende oder ähnlich durch den Plasmastrahl veränderbare Stoffe enthalten.

Weiter bevorzugt weist die Sonde eine Form auf, welche die Verschmutzung der Elektroden (z.B. durch eingefülltes Polymer) verhindert. Werden die Elektroden verschmutzt, ändern sich ihre elektrischen Eigenschaften, was dazu führen kann, dass das Plasma nicht oder nicht gleichmäßig gezündet wird und somit die beabsichtigte Modifizierung der Oberfläche auch nicht oder nicht gleichmäßig erfolgt.

Die Verschmutzung kann verhindert werden, indem sichergestellt wird, dass das Plasma ausreichend weit entfernt von den Elektroden, insbesondere in Behandlungsrichtung vor den Elektroden, auf das Polymer einwirkt, so dass das Polymer nicht auf die Elektroden gelangt.

Die Schlauchfüllung bzw. die plasmareaktiven Stoffe können beispielsweise in Pulverform, als Nanopartikel, kristallin, als Gase oder Gasgemische oder auch als Polymere (z.B. Silikon, PTFE) bereitgestellt werden. Je nach Stoff bietet sich die vorherige Befüllung oder die Zufuhr während der Beschichtung an.

Noch weiter bevorzugt weist ein kegelartiger Sondenkörper Nuten auf. Dadurch wird die Verteilung weiter erleichtert.

Nach einer weiteren vorteilhaften Ausführungsform weist der Sondenkörper Lamellen auf, die im Einsatz die Innenoberfläche des Schlauchs berühren. Durch derartige Lamellen könnte einerseits eine noch weitere Verteilung wie vorstehend erörtert stattfinden. Sind die Lamellen jedoch aus passendem Material und haben sie zudem eine Größe, die zu dem Durchmesser des Schlauchs passt, so dass sie gemeinsam mit dem Sondenkörper einen weitgehend gasdichten Abschluss des Schlauchs ermöglichen, kann auf einer Seite der Sonde ein Unterdruck generiert werden; beispielsweise um die Plasmaerzeugung zu erleichtern.

Wird eine solche Sonde so eingesetzt, dass unterschiedliche Drücke auf beiden Seiten derselben herrschen, kann vorzugsweise ein Druckregler auf einer Seite des Schlauchs angebracht sein. Dieser Druckregler dient dazu, den Druck des Gases auf dieser Seite (in der Regel den Druck des Plasmaträgergases) einzustellen.

Weiterhin kann die Sonde auch einen mit unter Überdruck stehendem Gas gefüllten Innenraum aufweisen. Das Gas kann beispielsweise durch Poren in der Sondenwand oder über ein Ventil ins Schlauchinnere austreten und dann unter Einfluss des Plasmas mit der Innenfläche des Schlauchs reagieren.

Selbstverständlich ist bei einer solchen Anordnung auch vorstellbar, dass eine Sonde mit zwei oder mehr Hohlräumen oder zwei oder mehr gekoppelte Sonden verwendet werden, um unterschiedliche Gase aufzubringen, die dann gleichzeitig und/oder nacheinander mit der Schlauchinnenwand reagieren. Auf diese Weise können ZweiKomponenten-Beschichtungen oder mehrere aufeinanderliegende Beschichtungen in einem Durchgang erzeugt werden.

Insbesondere bei mehreren gekoppelten Sonden kann auch das Halten über einen von der eigentlichen Plasmaerzeugung getrennten Sondenkörper geschehen. Dies hat den Vorteil, dass elektromagnetische Felder zum Halten und Bewegen der Sonde von der Plasmaerzeugung entfernt sind und somit den Plasmastrahl nicht stören. In diesem Fall ist eine nicht elektrisch leitende feste Kopplung zwischen den einzelnen Sondenteilen vorzusehen, um die Halte- und Bewegungskräfte sicher an die Stelle der Plasmaerzeugung zu übertragen.

Die vorstehend genannten Ausführungsformen schließen sich im Regelfall nicht aus, sondern können einander ergänzend eingesetzt werden. Beispielsweise ist es offensichtlich, dass eine Kombination der vorstehend erwähnten Kegelform des Sondenkörpers mit einer Ringelektrode und / oder einer durchgängigen Bohrung bei speziellen Anforderungen zweckmäßig sein kann.

Die Erfindung wird nachfolgend anhand der beigefügten Figuren beschrieben.
Fig. 1 zeigt eine erste Plasma-Beam-Sonde in einem im Querschnitt gezeigten Polymerschlauch.
Fig. 2 zeigt eine weitere Plasma-Beam-Sonde in einem im Querschnitt gezeigten Polymerschlauch.
Fig. 3 zeigt eine erfindungsgemäße Plasma-Beam-Sonde.
Fig. 4 zeigt eine weitere Sonde mit Lamellen und Poren.

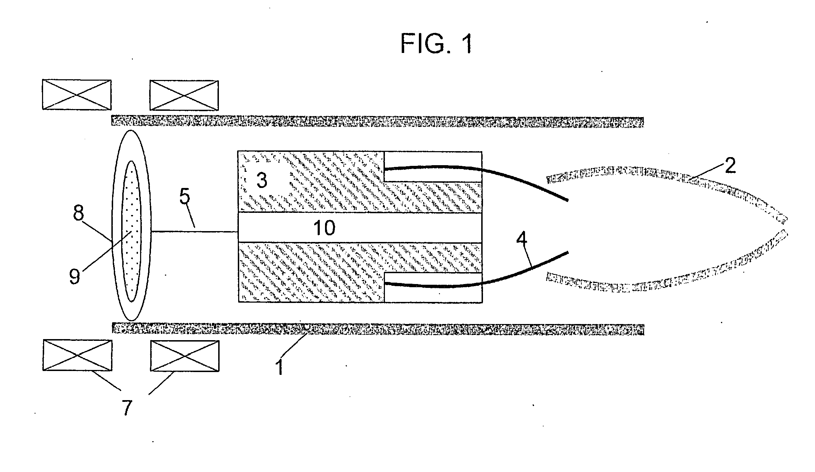

Fig. 1 zeigt eine Sonde 3 mit stirnseitiger Abgabe des Plasma-Beams bzw. Plasmastrahls 2 in einem strangförmigen Hohlkörper 1. Die Sonde weist in dieser Ausführungsform mindestens zwei isolierte Metallstäbe, -drähte oder -bleche 4 (oder allgemeiner elektrisch leitende, isolierte Elemente 4) auf. Diese Elemente sind vorzugsweise gleichmäßig voneinander beabstandet an der Sonde angeordnet. Die Sonde wird von außen gehalten und/oder relativ zu dem Schlauch bewegt. Idealerweise wird die Sonde berührungsfrei, z.B. elektromagnetisch durch den Schlauch 1 hindurch von außen gehalten. Dies wird in der Fig. durch zwei elektromagnetische Spulen 7 versinnbildlicht, zwischen denen ein mit der Sonde verbundener Magnetkörper mit einer Polymerummantelung 8 und einem Magnetkern 9 in der Schwebe gehalten ist. Der Magnetkörper ist mit der eigentlichen Sonde über einen Stab 5 fest verbunden, so dass Kräfte und Momente über den Stab 5 vom Körper auf die Sonde wirken können und die Sonde dadurch in dem Schlauch in der Schwebe gehalten wird, ohne an der Wand des Schlauchs zu haften. Dann kann der Schlauch durch (nicht gezeigte) Antriebe an der Vorrichtung vorbei gezogen werden, so dass eine Plasmabehandlung der Innenfläche erfolgt.

Insbesondere wenn mit einem Plasmaträgergas gearbeitet wird, das unter Umgebungsdruck steht, kann es zweckmäßig sein, in der Sonde 3 eine oder mehrere Durchgangsbohrungen 10 anzubringen. Diese Borhungen können vorzugsweise zentrisch und/oder symmmetrisch zwischen den beiden Stirnseiten der Sonde 3 angebracht sein. Die Bohrungen können gegebenenfalls so im Außenbereich der Sonde 3 verlaufen, dass sie zumindest abschnittsweise eine seitliche Oberfläche der Sonde in der Art einer Nut durchdringen. Durch derartige Bohrungen kann die Zufuhr von Luft bzw. Plasmaträgergas durch die Sonde hindurch erfolgen und dadurch der Widerstand gegen eine Bewegung der Sonde relativ zum Schlauch verringert werden.

Es ist natürlich auch - insbesondere in kurzen Schlauchstücken - möglich, die Sonde über einen Draht 5 von außen zu halten und mit Energie zu versorgen. Alternativ können Sonde und Körper 8 auch aus einem Stück gefertigt werden, wenn dabei eine Haltemöglichkeit verwendet wird, die den Plasmastrahl nicht wesentlich beeinflusst.

Von außen wird die Sonde 3 beispielsweise induktiv, kapazitiv oder über den Draht 5 mit Energie versorgt. Mit dieser Energie wird ein Feld zwischen den voneinander isolierten Metallstäben 4 aufgebaut. In einem (nicht gezeigten) geeigneten Plasmaträgergas wie einem Argon enthaltenden Gasgemisch, das die Stäbe umspült, erzeugt dieses Feld den Plasmastrahl 2. Dieser Plasmastrahl wird dann - möglicherweise gemeinsam mit vorab auf der Innenfläche aufgebrachten oder im Trägergas enthaltenen Komponenten - zur Modifikation der Innenoberfläche des Schlauches verwendet.

Die vorstehend beschriebene Ausführungsform eignet sich besonders für Schläuche mit kleinem Durchmesser in einer Größenordnung von unter 15 Millimetern. Bei größeren Durchmessern kann mit dieser Anordnung nicht mehr sicher gewährleistet werden, dass der Plasmastrahl die gesamte Innenoberfläche gleichmäßig bestreicht.

Falls größere Durchmesser zu behandeln sind, wird daher in einer weiteren Ausführungsform eine Plasmasonde gezeigt, die den Plasmastrahl seitlich abgibt.

Diese Sonde wird ebenso wie die in Fig. 1 gezeigte Sonde in dem Schlauch gehalten und mit Energie versorgt. Im Unterschied zu der vorstehend gezeigten Sonde weist sie jedoch nicht zwei Metallstäbe 4, sondern zwei ineinanderliegende Metallrohre bzw. Metallringe 4A, 4B auf. Sämtliche sonstigen Merkmale sind zu denen der in Fig. 1 gezeigten Sonde identisch; die entsprechenden Bezugszeichen sind daher nicht erneut aufgeführt.

Der äußere Metallring 4A ist vom inneren Metallring 4B isoliert in der Sonde gefasst. Der innere Metallring 4B verbreitert sich in einer vorgegebenen axialen Entfernung vom äußeren Metallring in der Art eines Flansches so, dass beide Ringe ungefähr gleich weit von der Schlauchwand beabstandet sind. Dadurch kann aufgrund der in der ersten Ausführungsform bereits beschriebenen Energiezufuhr zwischen den beiden Metallringen rundum ein Plasma-Beam-Ring entstehen, der die gesamte Innenoberfläche des Schlauches gleichmäßig bestreicht.

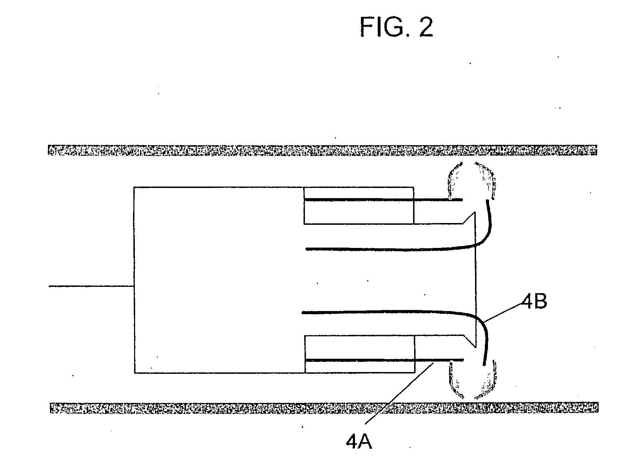

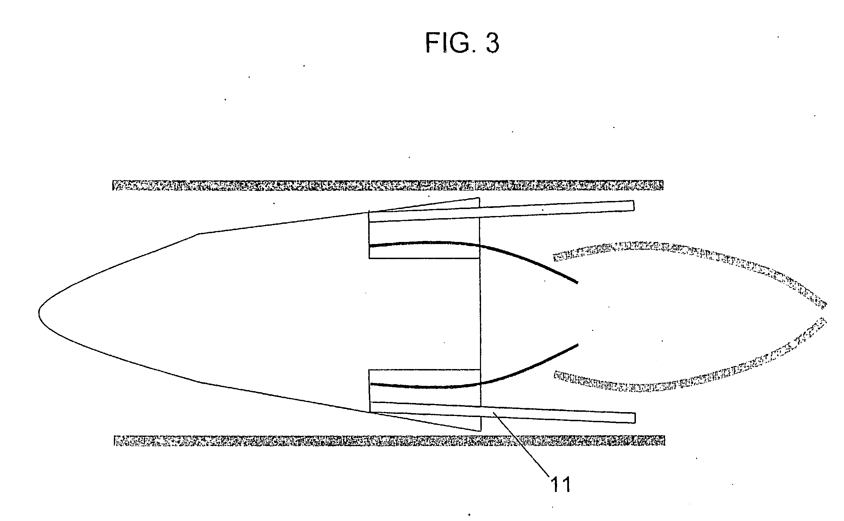

Selbstverständlich muss die Sonde auch nicht die schematisch in Fig. 1 und 2 gezeigte eckige bzw. zylindrische Grundform aufweisen. Die äußere Form der Sonde kann der Fachmann je nach Einsatzgebiet frei wählen. Erfindungsgemäß ist die Sonde 3 wie in Fig. 3 gezeigt kegelartig. Eine solche Kegelform ist vorteilhaft, wenn die Sonde 3 sich relativ zum Schlauch 1 hin zur Kegelspitze bewegt und gleichzeitig der Schlauch teilweise befüllt ist, beispielsweise mit einem (nicht gezeigten) pulverförmigen oder zähflüssigen Material, das unter Plasmaeinfluss auf den Schlauchinnenwänden polmerisiert oder in sonstiger Weise mit den Innenwänden reagiert, oder wenn der Schlauch schon "lose" mit einem Feststoff beschichtet ist, der mit dem Polymer verschmelzen oder in es eingebettet werden soll. In diesem Fall wird durch die Kegelform erreicht, dass das Material an den Innenwänden verteilt wird, so dass es an allen Seiten gleichmäßig an der Innenwand anliegt, wenn es mit dem Plasmastrahl reagiert.

Obwohl dies nicht im Einzelnen gezeigt ist, sollte in diesem Fall die Sonde relativ zum Schlauch in der Querrichtung besonders gut fixiert sein. Dies ist notwendig, weil ein gewisses Spiel zwischen der Sonde 3 und der Innenwand des Schlauchs 1 erforderlich ist, um das Material zwischen diesen Teilen passieren zu lassen. Andererseits darf das Material aber die Sonde nicht verdrängen, da sonst an einer Stelle ein Materialüberschuss auftreten und an einer anderen Stelle Material fehlen könnte.

Diese Fixierung kann beispielsweise wie vorstehend anhand der Fig. 1 beschrieben elektromagnetisch durch die Schlauchwand hindurch oder über eine Befestigung der Sonde, die auch in gewissem Maße Querkräfte übertragen kann, z.B. einen Stab, geschehen.

Um das Material noch besser zu verteilen, kann die Sonde 3 zudem (in den Figuren nicht gezeigte) Einkerbungen oder Nuten aufweisen. Die Nuten werden in der Regel gerade in Schlauchrichtung (Axialrichtung der Sonde) verlaufen, können aber beispielsweise auch schraubenförmig oder quer zur Schlauchrichtung verlaufen. Bei einem unter Normdruck arbeitenden Plasma-Beam-Verfahren können Nuten so vorgesehen sein, dass eine Luft-Plasmaträgergaszufuhr dabei mithilft, dass das Plasma sich in der gewünschten Form ausbreitet. Ferner kann selbstverständlich auch die Kegelform mit der vorstehend beschriebenen Ausführungsform mit Metallringen 4A,4B kombiniert werden, falls ein Schlauch mit größerem Durchmesser zu behandeln ist. Auch das in Fig. 1 gezeigte Loch kann möglicherweise bei einer Verteilung des Polymers in einer Sonde nach Fig. 3 eingesetzt werden.

Insbesondere bei festen oder flüssigen Materialien kann es notwendig werden, zu verhindern, dass die Materialien auf den Elektroden und nicht auf den Wänden des Schlauchs anhaften. Dies wird, wie in Fig. 3 gezeigt, beispielsweise durch einen Plasmaelektrodenschutz 11 erreicht, der die Plasmaelektroden vor von der Wand abblätterndem oder abtropfendem Material schützt. Dies kann notwendig sein, um zu verhindern, dass die Elektroden verunreiningt werden und dadurch das Plasma möglicherweise nicht mehr gleichförmig oder gar nicht mehr zünden bzw. induzieren können.

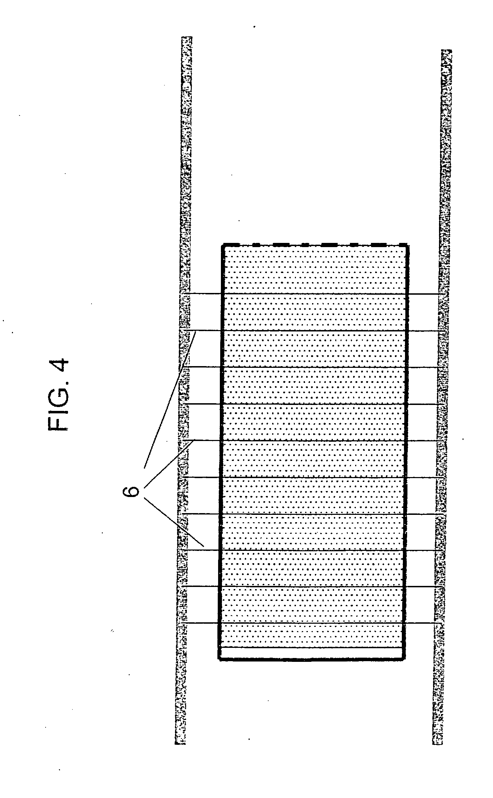

Bei der Plasmaerzeugung wird häufig ein Unterdruck benötigt. Um einen solchen Unterdruck in dem Schlauch erzeugen bzw. halten zu können, kann die erfindungsgemäße Plasma-Beam-Sonde 3 modifiziert werden, wie in Fig. 4 schematisch gezeigt.

Aus Gründen der Übersichtlichkeit wurden in Fig. 4 die Plasma erzeugenden Elemente 4 sowie die Fixierung 5, 7, 8 und 9 weggelassen; selbstverständlich sind solche Teile wie bei den bisher beschriebenen Ausführungsformen auch bei der hier vorliegenden Ausführungsform notwendig.

Der wesentliche Unterschied der in Fig. 4 gezeigten Ausführungsform gegenüber der Ausführungsform nach Fig. 1 liegt in den Lamellen 6, die am Sondenkörper 3 angebracht sind und den Schlauch in zwei gasdicht voneinander getrennte Druckräume teilen. Um die Dichtungsfunktion zu erfüllen, sind diese Lamellen 6 insbesondere in harten Hohlkörpern wie Metall- oder Glasrohren bevorzugt weich und elastisch verformbar. In einem weichen, elastischen Schlauch können jedoch auch härtere Lamellen für eine optimale Dichtung verwendet werden. Auf einer Seite der Sonde, auf der die Plasmaerzeugung 4 stattfindet, kann dann in bekannter Weise mittels eines (nicht gezeigten) Unterdruckreglers und einer zugehörigen Pumpe der Druck unter den Umgebungsdruck verringert und eingestellt werden. Pumpe und Unterdruckregler werden bevorzugt am Schlauchende angeordnet. In diesem Bereich kann dann wie in den vorstehend beschriebenen Ausführungsformen das Plasma gezündet werden, wobei ein Niederdruckplasme erzeugbar ist.

In einer weiteren Ausgestaltung dieser Ausführungsform ist es zudem möglich, das Plasmaträgergas in den Unterdruckbereich einzulassen, nachdem der Unterdruck erzeugt wurde, Dadurch kann das Plasmaträgergas unter Luftabschluss besonders rein zu der Plasmaerzeugungsstelle gelangen, was die Sauberkeit der Beschichtung verbessern kann. Außerdem können auch Gasgemische so zugeführt werden, die dann unter Plasmaeinfluss miteinander und mit den zu modifizierenden Innenflächen reagieren. Allerdings ist auf diese Weise nur eine einfache Beschichtung möglich; sollten mehrere Schichten übereinander aufgebracht werden, ist der Beschichtungsvorgang zu wiederholen.

In einer weiteren Ausgestaltung ist dagegen auch eine Beschichtung mit mehreren Schichten in einem Durchgang möglich: Hierzu wird das Sondeninnere mit einem Beschichtungswerkstoff, beispielsweise einem unter Überdruck stehenden Gas, gefüllt. Obwohl dies nicht gezeigt ist, können natürlich auch mehrere Kammern innerhalb der Sonde mit derartigen Werkstoffen gefüllt werden.

Dieser Werkstoff tritt dann entweder durch Poren in der Sondenwand oder über ein Ventil gesteuert in den Plasmastrahlbereich aus, wo er bei der Modifizierung der Innenwand mittels Plasmastrahl mitwirkt. Insbesondere beim Austritt durch Ventile aus mehreren Kammern in den Bereich des Plasmastrahls kann eine mehrfache Beschichtung erzielt werden, beispielsweise bei zwei mit Ventilen versehenen Kammern durch Öffnen eines Ventils, anschließendes Schließen des ersten und Öffnen des zweiten Ventils, durch Plasmamodifikation bei geschlossenen Ventilen oder Modifizierung bei zwei geöffneten Ventilen (Mischbeschichtung).

Ferner kann durch den einseitig erzeugten Unterdruck auch eine Kraft auf die Sonde ausgeübt werden, welche die Sonde in Richtung des Unterdrucks "saugt". Dadurch ist die Bewegung der Sonde in dem Schlauch einfach zu regeln. In diesem Fall fährt die Sonde mit den Lamellen kurz nach der Plasmabehandlung über die modifizierte Oberfläche.

Alternativ kann die Sonde durch die Schwerkraft nach unten gezogen werden. Dazu muss die Schwerkraft in einem Bereich des Schlauches gegen den Luftdruck wirken, in anderen Worten muss der Schlauch zumindest im Abschnitt, in dem die Plasmabehandlung stattfindet, im Wesentlichen senkrecht gelagert sein und der Unterdruck und damit der Plasmastrahl müssen oberhalb der Sonde erzeugt werden. Es ist selbstverständlich, dass "oberhalb der Sonde" in diesem Fall nur bedeutet, dass ein Abschnitt des Schlauchs oberhalb der Sonde sein muss, in dem Unterdruck erzeugt wird; die eigentlich Unterdruck erzeugende Pumpe bzw. das Schlauchende, aus dem die Luft unter Unterdruck abgesaugt wird, können beliebig gelagert sein.

Wie dem Fachmann beim Lesen der Beschreibung klar wird, können die vorstehend genannten Ausführungsformen beliebig kombiniert werden.

Zusammenfassend leistet die Erfindung Folgendes:

Es wird eine Sonde für die Modifikation von Innenflächen eines strangförmigen Hohlkörpers mittels eines Plasma-Beams geschaffen, der von außerhalb des Hohlkörpers Energie zugeführt wird. Die Sonde weist Vorrichtungen auf, um die Energie zur Erzeugung eines Plasmas im Hohlkörper zu nutzen. Weitere Vorrichtungen halten die Sonde an Ihrem Platz, wobei besonders bevorzugt eine berührungsfreie Halterung beispielsweise mittels elektormagnetischer Mittel verwendet wird. Zusätzlich werden verschiedene Weisen beschrieben, Material ins Hohlkörperinnere zuzuführen, das unter Plasmaeinfluss mit der Innenwand des Hohlkörpers reagiert.

### Bezugszeichenliste

- 1: Polymerschlauch (Strangförmiger Hohlkörper)
- 2: Plasmastrahl (Plasma-Beam)
- 3: Sonde
- 4 (A, B): Metallstäbe bzw. Metallringe oder -rohre
- 5: Draht
- 6: Lamellen
- 7: Spulen (elektromagnetische Haltevorrichtung)
- 8: Polymerummantelung
- 9: Magnetkern
- 10: Loch
- 11: Elektrodenschutz

## Patentansprüche

1. Verfahren zur Modifikation der Innenoberfläche eines strangförmigen Hohlkörpers (1) mittels eines Plasmas (2), mit den Schritten
zumindest teilweises Befüllen des strangförmigen Hohlkörpers (1) mit einem an den Innenwänden des Hohlkörpers zu verteilenden pulverförmigen oder zähflüssigen Material
Bewegen einer Sonde (3) im Inneren des Hohlkörpers (1) relativ zu diesem,
wobei die Sonde von außerhalb des Hohlkörpers zugeführte Energie über eine an einem Körper der Sonde (3) vorgesehene Einrichtung (4) zur Erzeugung eines Plasmas durch Energieabgabe an ein in den Hohlkörper (1) eingebrachtes Plasmaträgergas abgibt, und wobei
der Sondenkörper (3) in der Längsrichtung des strangförmigen Hohlkörpers (1) zum Verteilen des pulverförmigen oder zähflüssigen Materials kegelartig mit der Kegelspitze in Bewegungsrichtung der Sonde geformt ist.

2. Verfahren nach Anspruch 1 mit dem weiteren Schritt der Abgabe der an die Sonde (3) von außen zugeführten Energie an das Plasmaträgergas über die Einrichtung (4).

3. Verfahren nach Anspruch 1 oder 2, wobei die Sonde durch eine Vorrichtung (5, 7, 8, 9) gehalten wird.

4. Verfahren nach einem der vorhergehenden Ansprüche, wobei die Energie von außen über ein Kabel (5) durch den Hohlkörper (1) hindurch an die Sonde (3) zugeführt wird.

5. Verfahren nach Anspruch 3, wobei die Haltekraft über eine außerhalb des strangförmigen Hohlkörpers (1) angeordnete Vorrichtung (7) berührungsfrei auf den Sondenkörper übertragen wird.

6. Verfahren nach Anspruch 5, wobei die Haltekraft durch die Vorrichtung (7) elektromagnetisch übertragen wird.

7. Verfahren nach einem der Ansprüche 2 bis 6, wobei die Energie von der die Energie abgebenden Einrichtung (4) vorwiegend an einer Stirnfläche des Sondenkörpers abgegeben wird.

8. Verfahren nach einem der Ansprüche 2 bis 6, wobei die Energie von der die Energie abgebenden Einrichtung (4) vorwiegend an einer Umfangsfläche des Sondenkörpers abgegeben wird.

9. Verfahren nach einem der Ansprüche 1 bis 8, mit dem weiteren Schritt des Vorsehens von Nuten im Sondenkörper (3) entlang seiner Längsrichtung.

10. Verfahren nach Anspruch 1, wobei plasmareaktives Material und/oder durch den Plasmastrahl (2) veränderbare Stoffe enthaltendes Material durch die Sonde verdrängt wird.

11. Verfahren nach einem der vorhergehenden Ansprüche, wobei eine Verschmutzung der Energie abgebenden Vorrichtung (4) durch das pulverförmige oder zähflüssige Material auf Grund der Form der Sonde verhindert wird.

12. Verfahren nach einem der vorhergehenden Ansprüche, wobei das pulverförmige oder zähflüssige Material durch mindestens ein in Richtung der Bewegung der Sonde relativ zu dem Hohlkörper durch die Sonde hindurchgehendes Loch (10) treten kann.

13. Verfahren nach einem der vorhergehenden Ansprüche, wobeian dem Sondenkörper vorgesehene Lamellen (6) im Einsatz die Innenoberfläche des strangförmigen Hohlkörpers berühren.

14. Verfahren nach Anspruch 13, mit den weiteren Schritten des Definierens von Druckräumen auf beiden Seiten der Sonde (3) durch gasdichtes Anliegen der Lamellen an der Innenseite des strangförmigen Hohlkörpers (1), und
des Regelns des Druck in dem Hohlkörper (1) in dem Abschnitt des Hohlkörpers (1), der zwischen der Sonde (3) und einem axialen Ende des strangförmigen Hohlkörpers (1) liegt, mittels eines Druckreglers.

15. Verfahren nach einem der vorhergehenden Ansprüche, mit den weiteren Schritten
Vorsehen eines Hohlraums mit porösen Wänden und/oder Ventilen in der Sonde (3), Füllen des Hohlraums mit einem plasmareaktiven Gas, das unter einem höheren Druck steht als er am Einsatzort der Sonde in dem strangförmigen Hohlkörper herrscht, Austreten des Gases am Einsatzort aus der Sonde (3)

16. Verfahren nach einem der Ansprüche 13 bis 15, wobei das Gas über einen an einem axialen Ende des strangförmigen Hohlkörpers eingebauten Druckregler in den strangförmigen Hohlkörper zugeführt wird und über den Druckregler ein gewünschter Druck in dem Abschnitt des Hohlkörpers zwischen der Sonde (3) und dem Druckregler eingestellt wird.

17. System zur Durchführung des Verfahrens nach einem der vorhergehenden Ansprüche.

## Claims

1. Method for modifying the inner surface of an elongate hollow member (1) by means of a plasma (2) comprising the steps of
at least partially filling the elongate hollow member (1) with a powdered or viscous material which is intended to be distributed on the inner walls of the hollow member,
moving a probe (3) inside the hollow member (1) relative thereto, the probe emitting energy supplied from outside the hollow member via a device (4) provided on a body of the probe (3) in order to produce a plasma by emitting energy to a plasma carrier gas introduced into the hollow member (1), and
the probe body (3) in the longitudinal direction of the elongate hollow member (1) for distributing the powdered or viscous material being formed in a conical manner with the tip of the cone in the movement direction of the probe.

2. Method according to claim 1 with the additional step of discharging the energy supplied to the probe (3) from the outer side to the plasma carrier gas via the device (4).

3. Method according to claim 1 or claim 2, the probe being retained by means of a device (5, 7, 8, 9).

4. Method according to any one of the preceding claims, the energy being supplied from the outer side via a cable (5) through the hollow member (1) to the probe (3).

5. Method according to claim 3, the retention force being transmitted to the probe body in a contactless manner via a device (7) which is arranged outside the elongate hollow member (1).

6. Method according to claim 5, the retention force being transmitted by the device (7) in an electromagnetic manner.

7. Method according to any one of claims 2 to 6, the energy from the energy discharging device (4) being primarily discharged to a front face of the probe body.

8. Method according to any one of claims 2 to 6, the energy from the energy discharging device (4) being primarily discharged to a peripheral face of the probe body.

9. Method according to any one of claims 1 to 8, with the additional step of providing grooves in the probe body (3) along the longitudinal direction thereof.

10. Method according to claim 1, plasma reactive material and/or material containing substances which can be changed by the plasma stream (2) being forced through the probe.

11. Method according to any one of the preceding claims, contamination of the energy emitting device (4) by the powdered or viscous material being prevented owing to the shape of the probe.

12. Method according to any one of the preceding claims, the powdered or viscous material being able to pass through at least one hole (10) which extends through the probe in the direction of the movement of the probe relative to the hollow member.

13. Method according to any one of the preceding claims, blades (6) which are provided on the probe body coming into contact with the inner surface of the elongate hollow member during use.

14. Method according to claim 13, with the additional steps of defining pressure spaces at both sides of the probe (3) by means of gas-tight abutment of the blades at the inner side of the elongate hollow member (1), and
controlling the pressure in the hollow member (1) in the portion of the hollow member (1) which is located between the probe (3) and an axial end of the elongate hollow member (1), using a pressure regulator.

15. Method according to any one of the preceding claims, comprising the additional steps of
providing a hollow space with porous walls and/or valves in the probe (3),
filling the hollow space with a plasma reactive gas which is at a higher pressure than the pressure at the location at which the probe is used in the elongate hollow member, discharge of the gas from the probe (3) at the location of use.

16. Method according to any one of claims 13 to 15, the gas being conveyed into the elongate hollow member via a pressure regulator which is incorporated at an axial end of the elongate hollow member and a desired pressure in the portion of the hollow member between the probe (3) and the pressure regulator being adjusted by means of the pressure regulator.

17. System for carrying out the method according to any one of the preceding claims.

## Revendications

1. Procédé destiné à la modification de la surface intérieure d'un corps creux (1) tubulaire au moyen d'un plasma (2), comprenant les étapes suivantes
le remplissage au moins partiel du corps creux tubulaire (1) avec un matériau poudreux ou visqueux à répartir sur les parois intérieures du corps creux
le déplacement d'une sonde (3) à l'intérieur du corps creux (1) par rapport à celui-ci,
sachant que la sonde transmet de l'énergie amenée de l'extérieur du corps creux par le biais d'un dispositif (4) prévu sur un corps de la sonde (3) pour la génération d'un plasma par fourniture d'énergie à un gaz porteur de plasma introduit dans le corps creux (1), et
sachant que le corps de la sonde (3) est formé dans le sens longitudinal du corps creux (1) tubulaire pour la répartition du matériau poudreux ou visqueux comme un cône, dont la pointe se situe dans le sens de déplacement de la sonde.

2. Procédé selon la revendication 1 comprenant l'autre étape de transmission de l'énergie amenée à la sonde (3) de l'extérieur, au gaz porteur de plasma par le biais du dispositif (4).

3. Procédé selon la revendication 1 ou 2, sachant que la sonde est maintenue par un dispositif (5, 7, 8, 9).

4. Procédé selon l'une quelconque des revendications précédentes, sachant que l'énergie est amenée de l'extérieur par le biais d'un câble (5) passant au travers du corps creux (1) à la sonde (3).

5. Procédé selon la revendication 3, sachant que la force de retenue est transmise sans contact au corps de la sonde par le biais d'un dispositif (7) disposé en dehors du corps creux (1) tubulaire.

6. Procédé selon la revendication 5, sachant que la force de retenue est transmise par voie électromagnétique par le dispositif (7).

7. Procédé selon l'une quelconque des revendications 2 à 6, sachant que l'énergie est surtout transmise à une surface frontale du corps de la sonde par le dispositif fournissant l'énergie (4).

8. Procédé selon l'une quelconque des revendications 2 à 6, sachant que l'énergie est surtout transmise à une surface périphérique du corps de la sonde par le dispositif fournissant l'énergie (4).

9. Procédé selon l'une quelconque des revendications 1 à 8, comprenant l'autre étape de prévoyance de rainures dans le corps de la sonde (3) le long de son sens longitudinal.

10. Procédé selon la revendication 1, sachant que le matériau réactif au plasma et/ou le matériau contenant des substances modifiables par le jet de plasma (2) est déplacé par la sonde.

11. Procédé selon l'une quelconque des revendications précédentes, sachant que le matériau poudreux ou visqueux empêche que le dispositif fournissant l'énergie (4) ne se salisse en raison de la forme de la sonde.

12. Procédé selon l'une quelconque des revendications précédentes, sachant que le matériau poudreux ou visqueux peut pénétrer par au moins un trou (10) traversant la sonde en direction du mouvement de la sonde par rapport au corps creux.

13. Procédé selon l'une quelconque des revendications précédentes, sachant que des lamelles (6) prévues sur le corps de la sonde touchent en utilisation la surface intérieure du corps creux tubulaire.

14. Procédé selon la revendication 13, comprenant les autres étapes de définition d'espaces de pression des deux côtés de la sonde (3) par repos étanche au gaz des lamelles sur le côté intérieur du corps creux tubulaire (1), et
la régulation de la pression dans le corps creux (1) dans sa section qui est située entre la sonde (3) et une extrémité axiale du corps creux (1) tubulaire, à l'aide d'un régulateur de pression.

15. Procédé selon l'une quelconque des revendications précédentes, comprenant les autres étapes suivantes
la prévoyance d'un corps creux avec des parois poreuses et/ou des soupapes dans la sonde (3),
le remplissage du corps creux avec un gaz réactif au plasma à une pression supérieure à celle qui règne sur le site d'utilisation de la sonde dans le corps creux tubulaire,
la sortie du gaz hors de la sonde (3) sur le site d'utilisation.

16. Procédé selon l'une quelconque des revendications 13 à 15, sachant que le gaz est amené dans le corps creux tubulaire par un régulateur de pression intégré sur une extrémité axiale du corps creux tubulaire et une pression souhaitée est réglée par le régulateur de pression dans la section du corps creux entre la sonde (3) et le régulateur de pression.

17. Système de mise en oeuvre du procédé selon l'une quelconque des revendications précédentes.
